# EUROPEAN PATENT SPECIFICATION

(11) **EP 4 036 998 B1**
(45) Date of publication and mention of the grant of the patent: **28.01.2026**
(21) Application number: 22163535.2
(22) Date of filing: 24.06.2016
(51) Int. Cl.: H10K 59/80, H10K 77/10, H10K 102/00

(54) **FLEXIBLE DISPLAY DEVICE**
FLEXIBLE ANZEIGEVORRICHTUNG
AFFICHEUR SOUPLE

(30) Priority: 13.08.2015 KR 20150114888
(43) Date of publication of application: 03.08.2022
(62) Divisional of application: 16176231.5
(73) Proprietor: LG Display Co., Ltd., Seoul 150-721 (KR)
(72) Inventor: SON, HaeJoon, 413-012 Paju-si, Gyeonggi-do (KR); CHOI, SieHyug, 411-809 Goyang-si, Gyeonggi-do (KR); YOO, JuhnSuk, 03903 Seoul (KR); KIM, MoonGoo, 413-803 Paju-si, Gyeonggi-do (KR); PARK, Jehong, 130-792 Seoul (KR); KIM, Chiwoong, 10 845 Paju-si, Gyeonggi-do (KR)
(74) Representative: Viering, Jentschura & Partner mbB Patent- und Rechtsanwälte

(56) References cited:
- US-A1- 2010 293 782
- US-A1- 2013 034 685
- US-A1- 2014 021 499
- US-A1- 2015 137 098

## Description

### CROSS-REFERENCE TO RELATED APPLICATIONS

This application claims priority from Korean Patent Application No. 10-2015-0114888 filed on August 13, 2015, which is hereby incorporated by reference for all purposes as if fully set forth herein.

### BACKGROUND OF THE INVENTION

### Field of the Invention

The present disclosure relates to a flexible display device.

### Description of the Related Art

An organic light emitting diodes (OLED) display device, a plasma display panel (PDP) display device, or the like emitting light by themselves, a liquid crystal display device requiring a separate light source, or the like has been used in a monitor of a computer, a TV, a cellular phone, and the like.

Recently, a flexible display device, which is manufactured by forming a display panel, wiring, and the like on a flexible substrate such as a plastic of a flexible material so that an image can be displayed under a bent condition like paper, has been in the spotlight as a next generation display device.

The flexible display device has been variously applied to not only a monitor of a computer and a TV but also a personal mobile device, and a flexible display device having reduced volume and weight in spite of a wide display area has been studied.

In such flexible display device, crack occurs in the flexible substrate or the wiring based on various causes when bending the display device. This crack occurring in the flexible substrate or the wiring may cause a failure of the flexible display device.

US 2015/0137098 A1, US 2013/0034685 A1, US 2010/0293782A1, and US 2014/0021499A1 each describes a flexible display panel including a protective layer.

### SUMMARY OF THE INVENTION

The present invention provides a flexible display device according to claim 1. Further embodiments are described in the dependent claims.

The flexible display device may further comprise a first back plate and a second back plate. The first back plate may be disposed on a second surface of the flexible substrate to correspond to the display layer. The second back plate may be disposed to correspond to the drive integrated circuit connection member. The second back plate may be positioned under the first back plate when the flexible substrate is bent in the bending direction.

The drive integrated circuit connection member is at least one of a tape carrier package (TCP) and a chip on film (COF).

The flexible display device may further comprise a supporting member. The supporting member may be positioned between the first backplate and the secondbackplate in a vertical direction.

According to the aspects of the present invention, crack can be prevented from occurring in a flexible substrate or wiring when bending a flexible display device.

According to the aspects of the present invention, it is possible to prevent or minimize a failure in a flexible display device.

### BRIEF DESCRIPTION OF THE DRAWINGS

The above and other aspects, features and other advantages of the present invention will be more clearly understood from the following detailed description taken in conjunction with the accompanying drawings, in which:
FIG. 1 is a plan view of a flexible display device in a non-bent condition;
FIG. 2 is a cross section of a flexible display device under a bent condition;
FIG. 3 is a cross section of a flexible substrate, a display layer, and a connection member of a drive integrated circuit of the flexible display device of FIG. 2 under a non-bent condition;
FIGS. 4a to 4c are cross-sections of modified examples of the flexible display device of FIG. 2;
FIG. 5 is a diagram illustrating a process of manufacturing a cover coat of FIG. 2;
FIGS. 6a and 6b are diagrams illustrating a case that the cover coat is normally formed and a case that the cover coat is abnormally formed based on a process error when the cover coat is formed by using a jetting process of FIG. 5;
FIG. 7 is a cross section of the flexible display device according to an embodiment;
FIG. 8 is a cross section of a flexible substrate, a display layer, and a drive integrated circuit connection member of the flexible display device of FIG. 7 under a non-bent condition; and
FIGS. 9 to 11b are cross sections of modified examples of the flexible display device of FIG. 7.

### DETAILED DESCRIPTION OF THE PREFERRED EMBODIMENT

Hereinafter, some exemplary embodiments of the present invention will be described in detail with reference to the accompanying drawings. In adding reference numerals to components throughout the drawings, like reference numerals may designate like components even though components are shown in different drawings. Further, in explaining the exemplary embodiments of the present invention, a detailed explanation of well-known components or functions may be omitted to avoid unnecessarily obscuring the subject matter of the present invention.

Further, in describing components of the present invention, terms such as first, second, A, B, (a), (b), etc. can be used. These terms are used only to differentiate the components from other components. Therefore, the nature, order, sequence, or number of the corresponding components is not limited by these terms. It is to be understood that when one element is referred to as being "connected to" or "coupled to" another element, it may be directly connected to or directly coupled to another element, connected to or coupled to another element, having still another element "intervening" therebetween, or "connected to" or "coupled to" another element via still another element.

In this specification, a flexible display device means a display device with softness, and may be used to have a similar meaning to a bendable display device, a rollable display device, an unbreakable display device, a foldable display device, or the like. In this specification, a flexible OLED display device is an example of various flexible display devices.

In this specification, the display device has a display area and a non-display area. The display area is an area in which an image or the like is displayed, and the non-display area is an area in which an image is not displayed like a bezel.

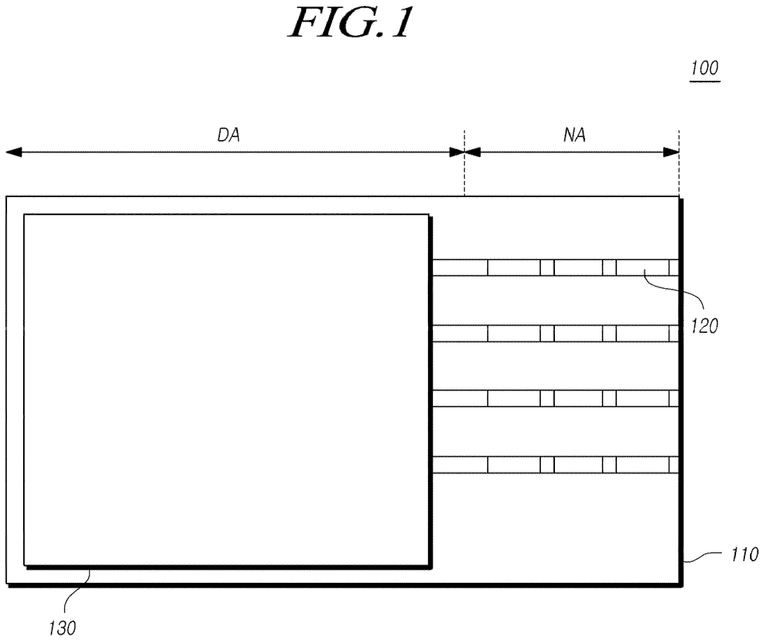

FIG. 1 is a plan view of a flexible display device according to an embodiment when the display device is not bent

Referring to FIG. 1, a flexible display device 100 includes a flexible substrate 110, wiring 120, and a display layer or display panel 130.

The flexible substrate 110 is a substrate that supports various elements of the flexible display device 100 and has softness. The flexible substrate 110 is named a soft substrate, a first soft substrate, or a flexible member. When being made of plastic, the flexible substrate 110 may be named a plastic film, a plastic substrate, or a first soft substrate. The flexible substrate 110 is formed in the shape of a rectangular parallelepiped, but is not limited thereto and can be formed in various shapes.

The flexible substrate 110 is made of soft material, for example, is a film including one selected from a group of polyester-based polymer, silicone-based polymer, acrylic polymer, polyolefin-based polymer, and copolymer of them. Specifically, the flexible substrate 110 includes one selected from a group of polyethylene terephthalate (PET), polybutylene terephthalate (PBT), polysilane, polysiloxane, polysilazane, polycarbosilane, polyacrylate, polymethacrylate, polymethylacrylate, polymethylmetacrylate, polyethylacrylate, polyethylmetacrylate, cyclic olefin copolymer (COC), cyclic olefin polymer (COP), polyethylene (PE), polypropylene (PP), polyimide (PI), polymethylmethacrylate (PMMA), polystyrene (PS), polyacetal (POM), polyetheretherketone (PEEK), polyester sulfone (PES), polytetrafluoroethylene (PTFE), polyvinyl chloride (PVC), polycarbonate (PC), polyvinylidene fluoride (PVDF), perfluoroalkyl polymers (PFA), a styrene acrylic polymer nitro rilko (SAN), and a combination of them. In some embodiments, when the flexible display device 100 is implemented by a transparent flexible display device, the flexible substrate 110 is formed of a transparent soft material.

The flexible substrate 110 includes a display area (DA) and a non-display area (NA). The display area (DA) of the flexible substrate is an area in which a real image is displayed and the non-display area of the flexible substrate 110 is an area in which an image is not displayed.

The non-display area (NA) of the flexible substrate 110 is an area extending from the display area (DA) of the flexible substrate 110. The non-display area (NA) of the flexible substrate 110 is an area extending from a side of the display area (DA) of the flexible substrate 110. For example, when the display area (DA) of the flexible substrate 110 is formed in a polygonal shape and the non-display area (NA) of the flexible substrate 110 extends from a side of the display area (DA) of the flexible substrate 110. The non-display area (NA) of the flexible substrate 110 which extends from a side of the display area (DA) of the flexible substrate 110 is illustrated in FIG. 1 for the convenience of description, but is not limited thereto. Therefore, the non-display area (NA) of the flexible substrate 110 may extend from a plurality of sides of the display area (DA) of the flexible substrate 110.

As the non-display area (NA) of the flexible substrate 110 is disposed in peripheral areas or edge areas of the display area (DA) of the flexible substrate 110 and various circuits for displaying image are arranged therein, the non-display area (NA) is named a peripheral area, a peripheral circuit area, an edge area, or a bezel area.

The display layer 130 is disposed in the entire area or a portion area of the display area (DA) of the flexible substrate 110. The display layer 130 is an element for displaying a real image, and is also named an image display layer. There is no limitation as long as the display layer 130 is an element capable of displaying an image. In this specification, the display layer 130 is an organic light-emitting display layer that includes an organic light-emitting device to display an image via an organic light-emitting layer and a thin film transistor to drive the organic light-emitting device.

The thin film transistor includes an active layer, a gate insulating layer, a gate electrode, an intermediate insulating layer disposed on the gate electrode and the active layer, and a source electrode and a drain electrode electrically connected to the active layer. The organic light-emitting device includes a first electrode electrically connected to anyone of the source electrode and the drain electrode, an organic light-emitting layer disposed on the first electrode, and a second electrode disposed on the organic light-emitting layer.

Various elements not displaying an image are disposed in the non-display area (NA) of the flexible substrate 110

The elements disposed in the non-display area (NA) of the flexible substrate 110 include various drive integrated circuits such as a gate drive integrated circuit or a data drive integrated circuit, drive circuit section, and the like. Here, the various drive integrated circuit and the drive circuit section are mounted in the flexible substrate 110 in the manner of aGate in Panel (GIP), or are connected to the flexible substrate 110 in the manner of a Tape Carrier Package (TCP) or a Chip On Film (COF).

The wiring 120 is disposed on the flexible substrate 110. The wiring 120 electrically connects the display layer 130 disposed in the display area (DA) of the flexible substrate 110 to the drive circuit section or the gate drive integrated circuit, and the data drive integrated circuit disposed in the non-display area (NA) of the flexible substrate 110 for signal transmission.

The wiring 120 is formed of a conductive material, and is formed of a conductive material with excellent softness in order to minimize the occurrence of a crack when bending the flexible substrate. For example, the wiring 120 is formed of a conductive material with excellent softness such as gold (Au), silver (Ag), aluminum (Al), and the like. However, constituents of the wiring 120 are not limited thereto, and the wiring 120 is formed of one of various conductive materials used in manufacturing the display layer 130, and specifically, may be formed of molybdenum (Mo), chrome (Cr), titanium (Ti), nickel (Ni), neodymium (Nd), copper (Cu), an alloy of silver (Ag) and magnesium (Mg), or the like that is one of various conductive materials used in manufacturing the display layer 130. The wiring 120 is formed in a multilayered structure including the various conductive materials described above. For example, the wiring 120 is formed in a three-layered structure of titanium (Ti) / aluminum (Al) / titanium (Ti), but is not limited thereto.

At least a portion area of the non-display area (NA) of the flexible substrate 110 is formed in a shape that is bent in a bending direction.

Here, at least the portion area of the non-display area (NA) of the flexible substrate 110 having a shape that is bent in the bending direction is named a bend area. As the non-display area (NA) of the flexible substrate 110 is not an area in which an image is displayed, the non-display area (NA) does not have to be acknowledged in the upper surface of the flexible substrate 110 and at least a portion area of the non-display area (NA) is bent. For the convenience of description, FIG. 1 illustrates a case that the entire non-display area (NA) of the flexible substrate 110 is the bend area. However, the bend area is not limited thereto and only a portion area of the non-display area (NA) of the flexible substrate 110 may be the bend area. For the convenience of description, FIG. 1 illustrates a case that the non-display area (NA) of the flexible substrate 110 is slightly narrower than the display area (DA) of the flexible substrate 110, but the non-display area (NA) of the flexible substrate 110 may be greatly narrower than the display area (DA) of the flexible substrate 110.

The bend area, which is at least a portion area of the non-display area (NA) of the flexible substrate 110, is formed in a shape that is bent in the bending direction. In FIG. 1, the bending direction is a lateral direction of the flexible substrate 110, and a case that the bend area being at least a portion area of the non-display area (NA) of the flexible substrate 110 is bent in the lateral direction of the flexible substrate 110 is illustrated.

Hereinafter, various flexible display devices under a bent condition will be described with reference to the accompanying drawings.

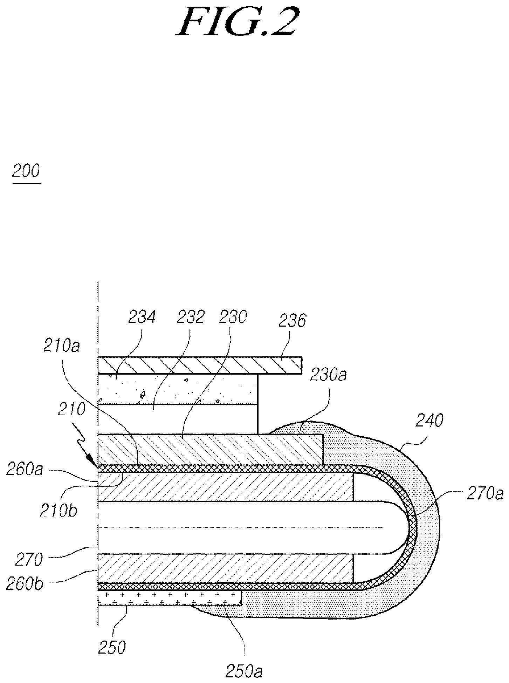

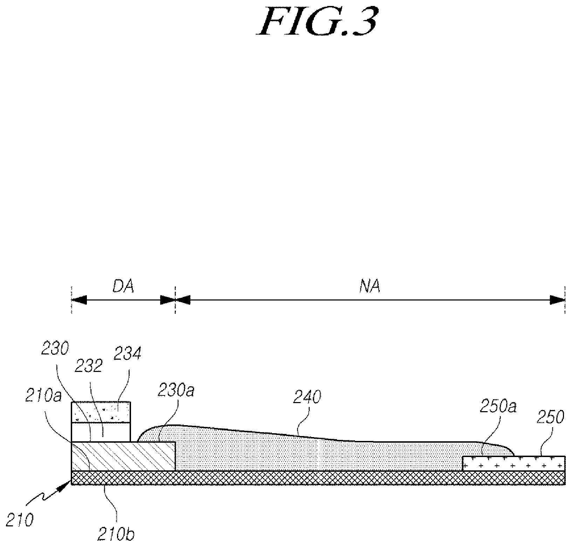

FIG. 2 is a cross section of a flexible display device under a bent condition. FIG. 3 is a cross section of a flexible substrate, a display layer, and a connection member of a drive integrated circuit of the flexible display device of FIG. 2 under a non-bent condition.

Referring to FIGS. 2 and 3, a flexible display device 200 is bent in a shape that at least a portion area of a non-display area (NA) of a flexible substrate 210 is bent in a bending direction.

A display layer 230 is disposed on a display area (DA) of a surface 210a of the flexible substrate 210.

A cover coat 240 is disposed on the non-display area (NA) of the surface 210a of the flexible substrate 210 to prevent moisture permeation or crack occurrence. The cover coat 240 is disposed in the bend area described with reference to FIG. 1.

A drive integrated circuit connection member 250 is connected to the non-display area (NA) of the surface 210a of the flexible substrate 210. Various drive integrated circuits such as a gate drive integrated or a data drive integrated circuit, a drive circuit section, and the like are mounted on the drive integrated circuit connection member 250. The drive integrated circuit connection member 250 is at least one of the tape carrier package (TCP) and the chip on film (COF).

The wiring 120 illustrated in FIG. 1 is disposed on the flexible substrate 210, but is not shown for the convenience of description.

The cover coat 240 is disposed between the display layer 230 and the drive integrated circuit connection member 250, and covers a portion 230a of the display layer 230 and a portion 250a of the drive integrated circuit connection member 250.

A polarizing layer 232 is disposed on the display layer 230, but is not limited thereto. A cover coat 236 is disposed on the polarizing layer 232, and the polarizing layer 232 and the cover coat 236 are bonded together by an adhesive layer 234.

At least a portion area of the non-display area (NA) of the flexible substrate 210 and the cover coat 240 is bent in a shape that is bent in the bending direction.

On the other surface 210b of the flexible substrate 210, a first back plate 260a that is disposed to correspond to the display layer 230 and a second back plate 260b that is disposed to correspond to the drive integrated circuit connection member 250 and is positioned under the first back plate 260a when the flexible substrate 210 is bent in the bending direction are disposed.

A supporting member 270 is positioned to be in contact with a bend area of the other surface 210b of the flexible substrate 210 between the first back plate 260a and the second back plate 260b in the vertical direction to support the flexible substrate 210. Ahead 270a of the supporting member 270 has a semicircular shape with a shorter radius than that of the bent flexible substrate 210. Therefore, the head 270a of the supporting member 270 is in surface to surface contact with the bend area of the other surface 210b of the flexible substrate 210.

When the flexible substrate 210 is bent in the bending direction, tension is caused in the flexible substrate 210. In the flexible substrate 210, the most powerful tension is caused in a direction equal to the bending direction, and crack occurs in itself or due to external impact, or the occurred crack propagates to the display layer 230. Such crack of the flexible substrate 210 may cause breaking of the wiring (not shown) disposed in the non-display area (NA). In bending, the wiring (not shown) is positioned in an intermediate surface by using the cover coat 240 so that the crack of the wiring can be prevented

In flexible display device 200, a bend of the display layer 230 is needed to reduce the bezel area, and the cover coat 240 is formed to prevent moisture permeation and crack occurrence in the bend area. It is possible to prevent crack occurrence by contacting the head 270a of the supporting member 270 to the bend area of the other surface 210b of the flexible substrate 210 in order to support the bend area.

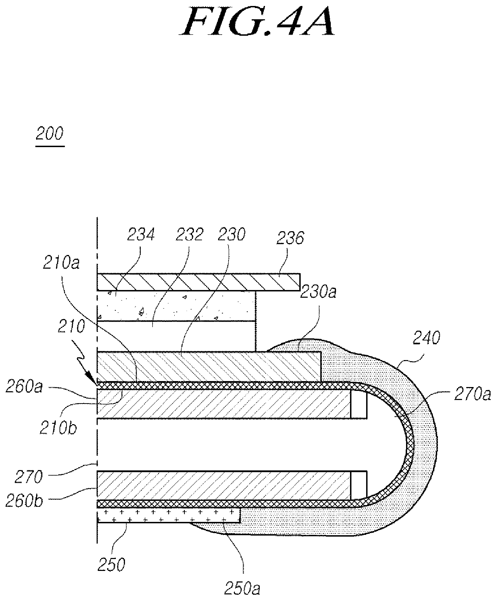

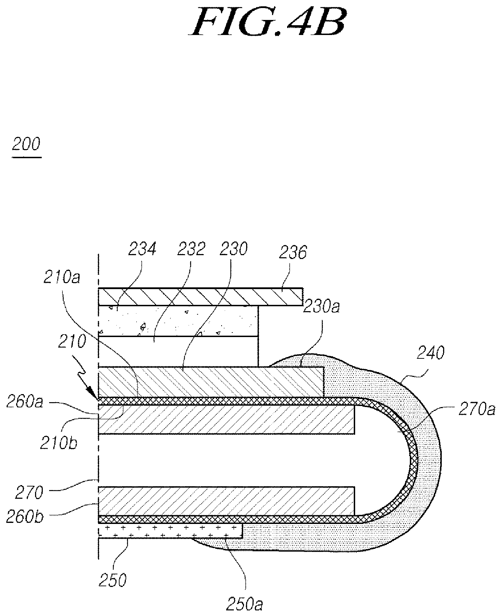

As illustrated in FIGS. 4a and 4b, when the head 270a of the supporting member 270 is configured to be a semicircular shape having a radius equal to a radius of the bend area of the flexible substrate 210 in the flexible display device 200 described above, the head 270a of the supporting member 270 is entirely in surface to surface contact with the other surface 210b of the flexible substrate 210 so that stability and curvature reliability of the supporting member 270 can be improved. Therefore, it is possible to improve the effect that the supporting member 270 prevents wiring crack in the entire bend area of the other surface 210b of the flexible substrate 210.

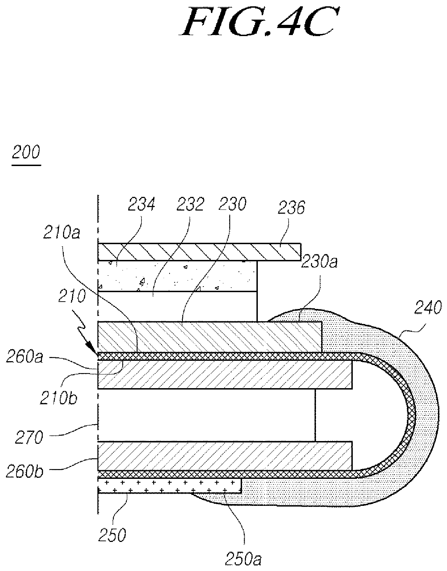

As illustrated in FIG. 4c, the supporting member 270 does not include the head 270a being entirely in surface to surface contact with the bend area of the other surface 210b of the flexible substrate 210, and thus occurrence of wiring crack caused by an impact with the supporting member 270 can be removed.

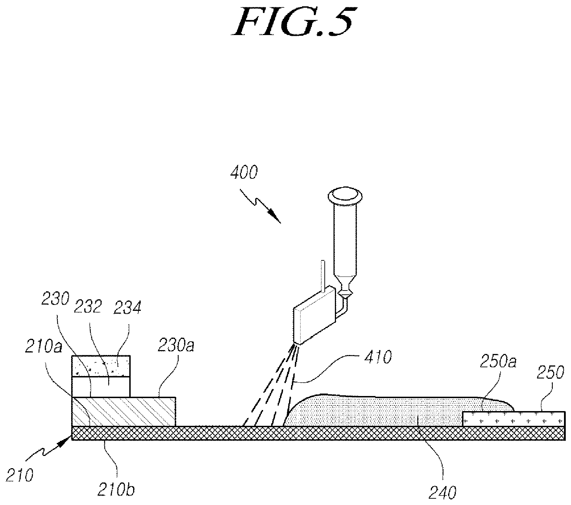

The covercoat 240 is formed by using various materials through various processes. For example, as illustrate in FIG. 5, the cover coat 240 is formed by coating organic resin (for example, acrylic resin) through the jetting process. The display layer 230 and the wiring (not shown) are formed in the display area (DA) and the non-display area (NA) of the flexible substrate 210, respectively. Then, while the drive integrate circuit connection member 250 in which a drive integrated circuit is mounted is connected to the flexible substrate 210, the cover coat 240 is formed by coating the organic resin 410 between an end 230a of the display layer 230 and an end of the drive integrated circuit connection member 250 using a jetting apparatus 240, and performing a hardening process by using ultraviolet (UV) or the like.

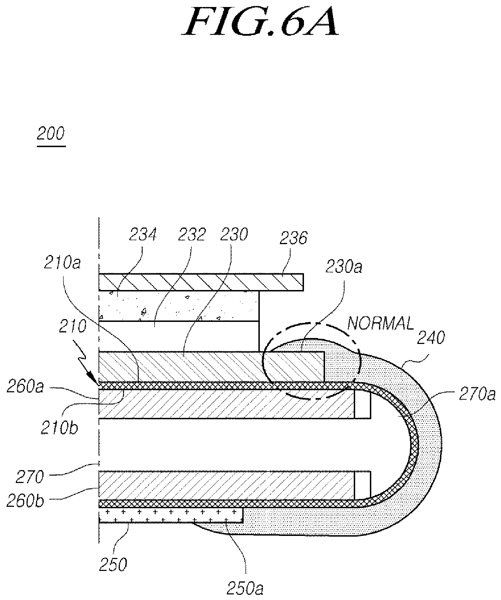

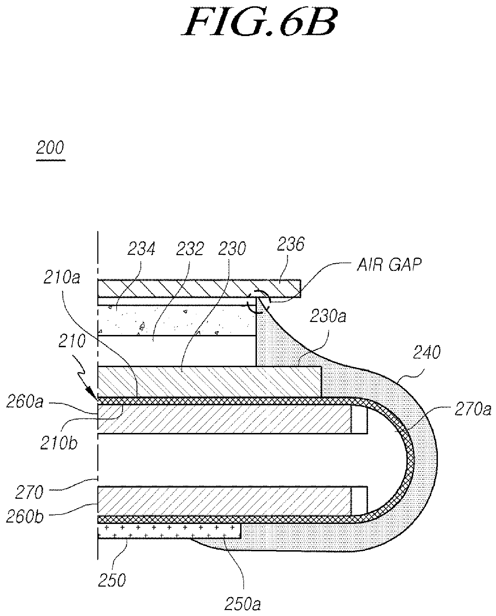

FIGS. 6a and 6b are diagrams of illustrating a case that the cover coat is normally formed and a case that the cover coat is abnormally formed based on a process error when the cover coat is formed by using the jetting process of FIG. 5

As illustrate in FIG. 6a, when the cover coat 240 is formed through the jetting process, as described above, the organic resin 410 for the cover coat 240 is to be coated on the end 230a of the display layer 230 and is not to be coated on the polarizing layer 232 on the display layer 230 or the adhesive layer 234 to bond the polarizing layer 232 and the cover coat 236 together. As illustrated in FIG. 6b, due to a process error of the jetting process, the organic resin 410 may be coated on the polarizing layer 232 on the display layer 230 or the adhesive layer 234 to bond the polarizing layer 232 and the cover coat 236 together. If the organic resin 410 is coated on the adhesive layer 234 to bond the polarizing layer 232 and the cover coat 236 together due to the process error and is hardened, an air gap may occur between the adhesive layer 234 and the cover coat 236 due to a portion of the cover coat 240 protruding over the adhesive layer 234 when the cover coat 236 and the polarizing layer 232 are bonded by using the adhesive layer 234. Bubbles occur between the adhesive layer 234 and the cover coat 236, and thus adhesion failure of the cover coat 236 or panel failure may be caused.

Hereinafter, embodiments of a flexible display device, in which adhesion failure of a cover or panel failure can be improved although a cover coat is formed in a flexible substrate by using the jetting process, will be described with reference to the accompanying drawings.

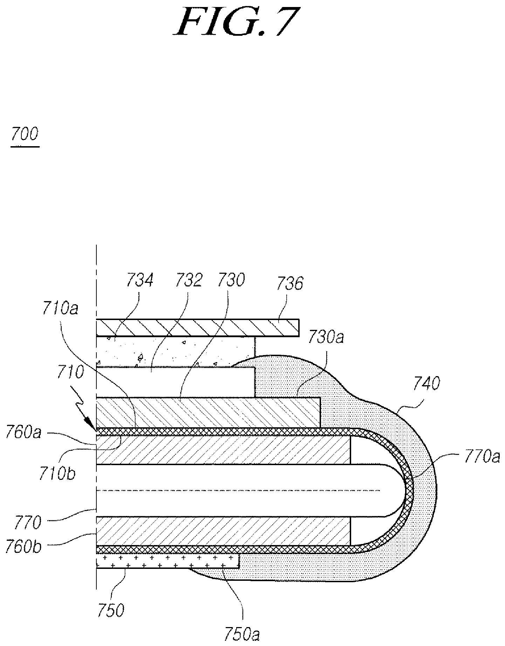

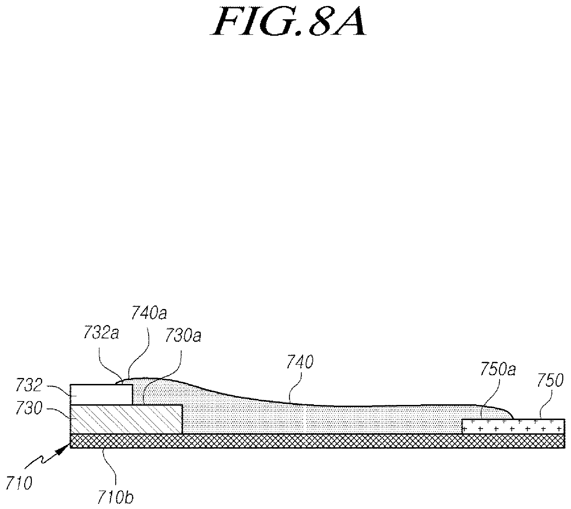

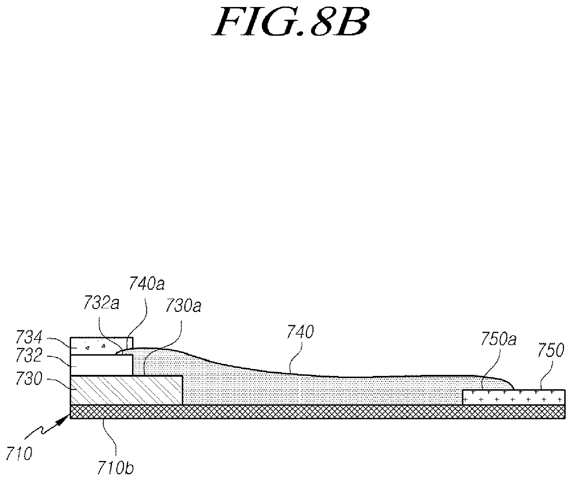

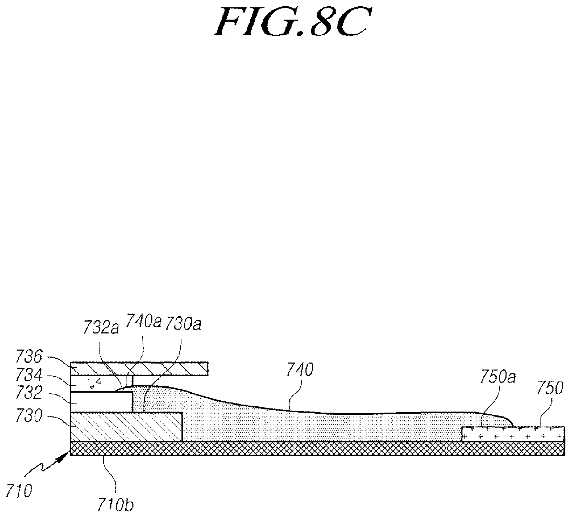

FIG. 7 is a cross section of the flexible display device according to an embodiment. FIG. 8 is a cross section of a flexible substrate, a display layer, and a drive integrated circuit connection member of the flexible display device of FIG. 7 under a non-bent condition.

Referring to FIGS. 7 and 8, a flexible display device 700 according to an embodiment includes a flexible substrate 710 having a display area (DA) and a non-display area (NA) extending from the display area (DA), a display layer 730 disposed in the display area (DA) of the flexible substrate 710, a polarizing layer 732 disposed on the display layer 730, and a cover coat 740 disposed in the non-display area (NA) of the flexible substrate 710.

The flexible display device 700 includes a first back plate 760a that is disposed on a surface 710b of the flexible substrate 710 to correspond to the display layer 730, and a second backplate 760b that is disposed on the surface 710b of the flexible substrate 710 and separated from the first back plate 760a.

The flexible display device 700 includes a supporting member 770 positioned between the first back plate 760a and the second back plate 760b in the vertical direction and is separated from the flexible substrate 710. As illustrated in FIG. 7, the head 770a of the supporting member 770 is a semicircular shape bigger than the body and has the same radium as a radius of the bent flexible substrate 710, and the head 770a of the supporting member 770 is entirely in surface to surface contact with a bend area of the other surface 710b of the flexible substrate 710, so that stability and curvature reliability of the supporting member 770 can be improved. Here, the head 770a of the supporting member 770 may have the same shape as the heads described in FIGS. 2 to 4c. The supporting member 770 may not have the head 770a as described FIG. 4c.

As illustrated in FIG. 1, wiring (not shown) is disposed on the flexible substrate 710. The wiring electrically connects the display layer 730 disposed in the display area (DA) of the flexible substrate 710 to the drive circuit section or the gate drive integrated circuit, and the data drive integrated circuit disposed in the non-display area (NA) of the flexible substrate 710 for signal transmission. The wiring is formed of a conductive material, and is formed of a conductive material with excellent softness in order to minimize the occurrence of a crack when bending the flexible substrate 710.

A drive integrated circuit connection member 750 is connected to the non-display area (NA) of the flexible substrate 710, and the cover coat 740 is positioned between the display layer 730 and the drive integrated circuit connection member 750. As illustrated in FIG. 7, the cover coat 740 is positioned between the display layer 730 and the drive integrated circuit connection member 750. As described above, the drive integrated circuit connection member 750 is one of the tape carrier package (TCP) or the chip on film (COF).

At least a portion area of the non-display area (NA) of the flexible substrate 710 is positioned to have a shape that is bent in a bending direction.

The flexible display device 700 includes the cover coat 740 that is disposed in the non-display area (NA) of a surface 710a of the flexible substrate 710 and positioned to have a shape bent in the bending direction. The cover coat 740 is also positioned to have a shape bent in the bending direction similarly to the at least a portion area of the non-display area (NA) of the flexible substrate 710.

An intermediate surface is disposed between the at least a portion area of the non-display area (NA) of the flexible substrate 710 positioned to have a shape that is bent in a bending direction and the cover coat 740. Specifically, the wiring positioned in the non-display area (NA) of the flexible substrate 710 configures the intermediate surface by dint of the flexible substrate 710 and the cover coat 740. When the at least partial area of the non-display area (NA) of the flexible substrate 710 and the cover coat 740 are bent in the bending direction, aposition in which strains of at least a portion area of the non-display area (NA) of the flexible substrate 710 and the cover coat 740 caused by the bending become zero is named the intermediate surface.

A polarizing layer 732, a cover coat 736, and a first adhesive layer 734 bonding the polarizing layer 732 and the cover coat 736 together are positioned on the display layer 730.

As illustrated in FIG. 8a, in a state that the display layer 730 and the polarizing layer 732 are positioned in the display area (DA) of the flexible substrate 710 and the drive integrated circuit connection member 750 is connected to the non-display area (NA) of the flexible substrate 710, an organic resin is coated from the drive integrated circuit connection member 750 of the non-display area (NA) of the flexible substrate 710 to the display layer 730 and an end 732a of the polarizing layer 732 of the display area (DA) of the flexible substrate 710 by using the jetting process of FIG. 5, and then is hardened.

Next, as illustrated in FIGS 8b and 8c, an end 740a of the cover coat 740 is disposed on the end 730a of the display layer 730 and the end 732a of the polarizing layer 732. The first adhesive layer 734 and the cover coat 736 are directly bonded together on the polarizing layer 732. Then, in a state that a support structure of the first back plate 760a, the second back plate 760b, and the supporting member 770 is positioned on the other surface 710b of the flexible substrate 710, a bend area of the flexible substrate 710 is bent so that the flexible display device 700 illustrated in FIG. 7 can be obtained.

In the flexible display device 700 illustrated in FIG. 8a, the cover coat 740 is formed by using the jetting process before bonding the first adhesive layer 734 to the polarizing layer 732. Thus, when the organic resin 410 is coated over the polarizing layer 732 due to the process error, the end 740a of the cover coat 740 is positioned between the polarizing layer 732 and the first adhesive layer 734 on the polarizing layer 732. As an air gap does not occur between the first adhesive layer 734 and the cover coat 736, it is possible to minimize or prevent adhesive layer failure of the cover coat 736 or panel failure caused by the air gap occurring between the first adhesive layer 734 and the cover coat 736.

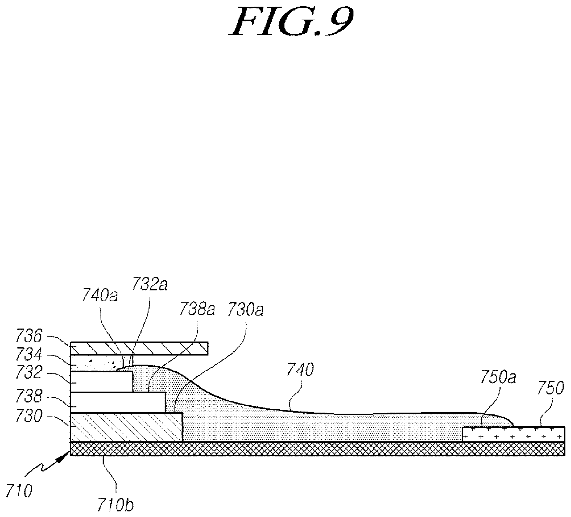

As illustrated in FIG. 9, the flexible display device 700 includes a barrier layer 738 between the display layer 730 and the polarizing layer 732. When the flexible display device 700 includes the barrier layer 738, the end 740a of the cover coat 740 is positioned between the polarizing layer 732 and the first adhesive layer 734 on the barrier layer 738 and the polarizing layer 732. Specifically, the end 740a of the cover coat 740 is positioned between the polarizing layer 732 and the first adhesive layer 734 on an end 738a of the barrier layer 738 and the end 732a of the polarizing layer 732.

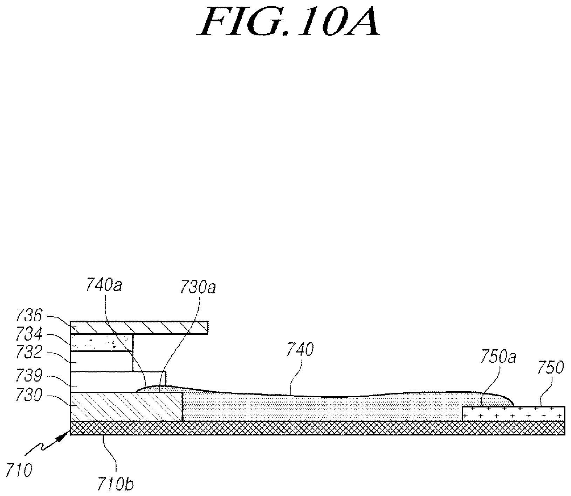

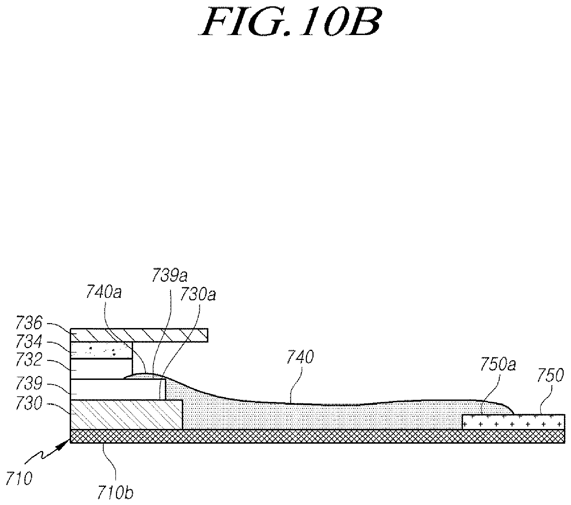

As illustrated in FIGS. 10a and 10b, the flexible display device 700 includes a second adhesive layer 739 between the polarizing layer 732 and the display layer 730 when not including the barrier layer 738. The flexible display device 700 includes the second adhesive layer 739 between the polarizing layer 732 and the barrier layer 738.

The end 740a of the cover coat 740 is positioned between the polarizing layer 732 and the first adhesive layer 734, or is positioned between the second adhesive layer 739 and the polarizing layer 732.

As illustrated in FIG. 10a, when the barrier layer 738 is not included, the end 740a of the cover coat 740 is positioned between the display layer 730 and the second adhesive layer 739 on the display layer 730. Specifically, the end 740a of the cover coat 740 is positioned between the display layer 730 and the second adhesive layer 739 on the end 730a of the display layer 730.

As illustrated in FIG. 10b, when the barrier layer 738 is not included, the end 740a of the cover coat 740 is positioned between the second adhesive layer 739 and the polarizing layer 732 on the second adhesive layer 739. Specifically, the end 740a of the cover coat 740 is positioned between the second adhesive layer 739 and the polarizing layer 732 on the end 739a of the second adhesive layer 739.

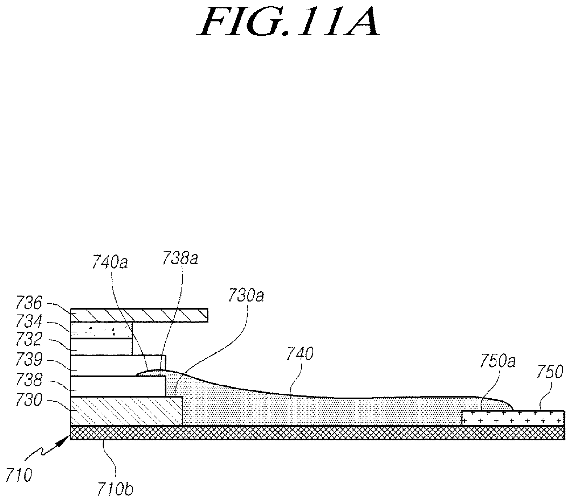

As illustrated in FIG. 11a, when the barrier layer 738 is included, the end 740a of the cover coat 740 is positioned between the barrier layer 738 and the second adhesive layer 739 on the barrier layer 738. Specifically, the end 740a of the cover coat 740 is positioned between the barrier layer 738 and the second adhesive layer 739 on the end 738a of the barrier layer 738.

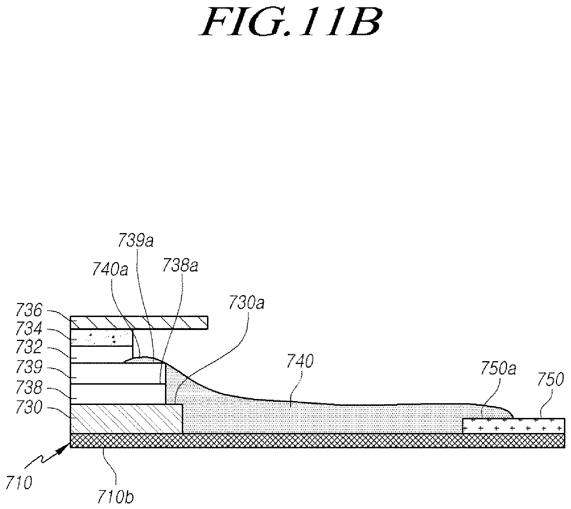

As illustrated in FIG. 11b, when the barrier layer 738 is included, the end 740a of the cover coat 740 is positioned between the second adhesive layer 739 and the polarizing layer 732 on the second adhesive layer 739. Specifically, the end 740a of the cover coat 740 is positioned between the second adhesive layer 739 and the polarizing layer 732 on the end 739a of the second adhesive layer 739.

In the embodiments described above, the cover coat 740 is positioned in the non-display area (NA) of the surface 710a of the flexible substrate 710, and the end 740a is disposed under the polarizing layer 732 or on the polarizing layer 732. That is, the end 740a of the cover coat 740 is positioned on at least one of the display layer 730, the barrier layer 738, the second adhesive layer 739, the polarizing layer 732, and the first adhesive layer 734. In forming the cover coat 740 by coating the organic resin 410 through the jetting process of FIG. 5, any one of the display layer 730, the barrier layer 734, the second adhesive layer 739, the polarizing layer 732, and a first adhesive layer 734 is positioned on the display layer 730 as an element on which the end 740a of the cover coat 740 is positioned, and then the organic resin 410 is coated through the jetting process of FIG. 5.

In the embodiments described above, the cover coat 740 is positioned in the non-display area (NA) of the surface 710a of the flexible substrate 710 and the end 740a is positioned under the polarizing layer 732 or on the polarizing layer 732. As a result, an air gap does not occur between the adhesive layer 734 and the cover coat 736, and it is possible to minimize or prevent adhesion failure of the cover coat 736 or panel failure by dint of the air gap occurring between the adhesive layer 734 and the cover coat 740.

As illustrated in FIGS. 7 to 11b, the drive integrated circuit connection member 750 is connected to the non-display area (NA) of the surface 710a of the flexible substrate 710, and the cover coat 740 can cover an end of the drive integrated circuit connection member 750.

As described above, in the other surface 710b of the flexible substrate 710, the first back plate 760a is disposed to correspond the display layer 730, and the second back plate 760b is disposed to correspond the drive integrated circuit connection member 750 and is positioned under the first back plate 760a when the flexible substrate 710 is bent in the bending direction. A supporting member 770 is positioned between the first backplate 760a and the second back plate 760b in the vertical direction.

Referring to FIGS. 2 and 4a to 4c, the flexible display device 700 illustrated in FIG. 7 includes at least one of the first back plate 760a, the second back plate 760b, and the supporting member 770 under a bent condition, but is not limited thereto. The support structure of the other surface 710b of the flexible substrate 710 is variously implemented.

According to the embodiments described above, it is possible to prevent an occurrence of the crack in the flexible substrate or wiring when the flexible display device is bent.

According to the embodiments described above, it is possible to prevent or minimize failure in the flexible display device.

The following examples pertain to further embodiments.

Example 1: A flexible display device, comprising: a flexible substrate including a display area and a non-display area; a display layer on the display area of the flexible substrate, the display layer being disposed on a first surface of the flexible substrate; at least one additional layer on the display layer; and a cover coat on the non-display area of the flexible substrate, the cover coat being disposed on the first surface of the flexible substrate; wherein at least a portion of the non-display area of the flexible substrate and the cover coat are bendable in a bending direction; and wherein an end of the cover coat is positioned between two neighboring ones of the layers disposed on the display area.

Example 2: The flexible display device according to Example 1, wherein the at least one additional layer on the display layer comprises a first adhesive layer on a polarizing layer or a second adhesive layer under a polarizing layer, and wherein the end of the cover coat is positioned between the polarizing layer and the first adhesive layer, or between the second adhesive layer and the polarizing layer, respectively.

Example 3: The flexible display device according to Example 2, further comprising a barrier layer between the display layer and the polarizing layer.

Example 4: The flexible display device according to Example 1, wherein the at least one additional layer on the display layer comprises an adhesive layer on the display layer, and the end of the cover coat is positioned between the display layer and the adhesive layer.

Example 5: The flexible display device according to Example 1, wherein the at least one additional layer on the display layer comprises a barrier layer on the display layer, and the end of the cover coat is positioned between the display layer and the barrier layer.

Example 6: The flexible display device according to Example 1, wherein the at least one additional layer on the display layer comprises a barrier layer on the display layer, and an adhesive layer on the barrier layer, and wherein the end of the cover coat is positioned between the barrier layer and the adhesive layer.

Example 7: The flexible display device according to any one of Examples 1 to 6, wherein the at least one additional layer in the display area comprises a cover layer.

Example 8: The flexible display device according to Example 1, wherein the at least one additional layer in the display area comprises a polarizing layer and a cover layer, and an adhesive layer is disposed between the polarizing layer and the cover layer.

Example 9: The flexible display device according to any one of Examples 1 to 8, wherein a drive integrated circuit connection member is connected to the non-display area of the surface of the flexible substrate, and the cover coat covers an end of the drive integrated circuit connection member.

Example 10: The flexible display device according to any one of Examples 1 to 9, further comprising: a first back plate which is disposed on a second surface of the flexible substrate to correspond to the display layer, and a second back plate which is disposed on the second surface of the flexible substrate to correspond to a drive integrated circuit connection member and which is positioned under the first back plate in a constellation in which the flexible substrate has been bent in the bending direction.

Example 11: The flexible display device according to Example 10, wherein the drive integrated circuit connection member is at least one of a tape carrier package (TCP) and a chip on film (COF).

Example 12: The flexible display device according to Example 10 or 11, further comprising: a supporting member which is positioned between the first back plate and the second back plate in a constellation in which the flexible substrate has been bent in the bend.

The foregoing description and the accompanying drawings are provided only to illustrate the technical conception of the present invention, but it will be understood by a person having ordinary skill in the art that various modifications and changes such as combinations, separations, substitutions, and alterations of the components may be made without departing from the scope of the present invention which is defined in the appended claims.

## Claims

1. A display apparatus (700), comprising:
a flexible substrate (710) including a display area (DA) and a non-display area (NA);
the non-display area (NA) including a first area, a bend area and a second area, the second area bent behind the first area via the bend area;
a display layer (730) on the flexible substrate (710);
an adhesive layer (739) on the display layer (730);
a polarizing layer (732) on the adhesive layer (739);
a cover layer (736) on the polarizing layer (732);
a second adhesive layer (734) located between the polarizing layer (732) and the cover layer (736);
a drive integrated circuit connection member (750) on the second area;
a wiring (120) routed from the first area to the second area via the bend area, the wiring (120) electrically connecting the display layer (130, 730) disposed in the display area (DA) to the drive integrated circuit connection member (750) disposed in the second area;
a cover coat (740) covering the wiring (120) in the bend area, the cover coat (740) having an edge portion between the display layer (730) and the adhesive layer (739), the cover coat (740) covering an end of the drive integrated circuit connection member (750),
wherein the cover coat (740) is disposed apart from the cover layer (736).

2. The display apparatus (700) of claim 1, further comprising a first back plate (760a) and a second back plate (760b) under the first back plate (760a);
wherein the first back plate (760a) is located below the flexible substrate (710) to correspond to the display layer (730) of the display area (DA) and the second back plate (760b) is located above the flexible substrate (710) to correspond to the drive integrated circuit connection member (750) of the second area.

3. The display apparatus (700) of claim 2, wherein a bottom surface of the first back plate (760a) faces a top surface of the second back plate (760b).

4. The display apparatus (700) of claim 3, further comprising a supporting member (770) located between the first back plate (760a) and the second back plate (760b).

5. The display apparatus (700) of claim 4, wherein the supporting member (770) is attached to the first back plate (760a) and the second back plate (760b).

6. The display apparatus (700) of any of claims 1 to 5, wherein the wiring is formed of gold, silver, aluminum, molybdenum, chrome, titanium, nickel, neodymium, copper, or an alloy of silver and magnesium.

7. The display apparatus (700) of any of claims 1 to 5, wherein the wiring is formed in a three-layered structure of titanium / aluminum / titanium.

8. The display apparatus (700) of any of claims 1 to 7, wherein the drive integrated circuit connection member (750) is at least one of a tape carrier package (TCP) and a chip on film (COF).

9. The display apparatus (700) of any of claims 1 to 8, wherein the cover coat (740) has a first thickness in the first area, and a second thickness in the bend area, and wherein the first thickness is greater than the second thickness.

10. The display apparatus (700) of any of claims 1 to 9, wherein the cover coat (740) comprises an organic resin.

11. The display apparatus of any of claims 1 to 10, wherein the cover coat (740) entirely covers a side surface of the display layer (730) and covers a part of an upper surface of the display layer (730).

## Patentansprüche

1. Anzeigevorrichtung (700), aufweisend:
ein flexibles Substrat (710) aufweisend einen Anzeigebereich (DA) und einen Nicht-Anzeigebereich (NA),
wobei der Nicht-Anzeigebereich (NA) einen ersten Bereich, einen Biegebereich und einen zweiten Bereich aufweist, wobei der zweite Bereich über den Biegebereich hinter den ersten Bereich gebogen ist,
eine Anzeigeschicht (730) auf dem flexiblen Substrat (710),
eine Klebeschicht (739) auf der Anzeigeschicht (730),
eine Polarisierungsschicht (732) auf der Klebeschicht (739),
eine Deckschicht (736) auf der Polarisierungsschicht (732),
eine zweite Klebeschicht (734), die zwischen der Polarisierungsschicht (732) und der Deckschicht (736) angeordnet ist,
ein Ansteuer-Integrierte-Schaltung-Verbindungselement (750) auf dem zweiten Bereich,
eine Verdrahtung (120), die vom ersten Bereich über den Biegebereich zum zweiten Bereich geführt ist, wobei die Verdrahtung (120) die im Anzeigebereich (DA) angeordnete Anzeigeschicht (130, 730) elektrisch mit dem im zweiten Bereich angeordneten Ansteuer-Integrierte-Schaltung-Verbindungselement (750) verbindet,
eine Abdeckbeschichtung (740), die die Verdrahtung (120) im Biegebereich abdeckt, wobei die Abdeckbeschichtung (740) einen Randabschnitt zwischen der Anzeigeschicht (730) und der Klebeschicht (739) hat, wobei die Abdeckbeschichtung (740) ein Ende des Ansteuer-Integrierte-Schaltung-Verbindungselements (750) abdeckt,
wobei die Abdeckbeschichtung (740) getrennt von der Deckschicht (736) angeordnet ist.

2. Anzeigevorrichtung (700) gemäß Anspruch 1, ferner aufweisend eine erste Rückplatte (760a) und eine zweite Rückplatte (760b) unter der ersten Rückplatte (760a),
wobei die erste Rückplatte (760a) unter dem flexiblen Substrat (710) angeordnet ist, um mit der Anzeigeschicht (730) des Anzeigebereichs (DA) zu korrespondieren, und die zweite Rückplatte (760b) über dem flexiblen Substrat (710) angeordnet ist, um mit dem Ansteuer-Integrierte-Schaltung-Verbindungselement (750) des zweiten Bereichs zu korrespondieren.

3. Anzeigevorrichtung (700) gemäß Anspruch 2, wobei eine untere Fläche der ersten Rückplatte (760a) einer oberen Fläche der zweiten Rückplatte (760b) zugewandt ist.

4. Anzeigevorrichtung (700) gemäß Anspruch 3, ferner aufweisend ein Stützelement (770), das zwischen der ersten Rückplatte (760a) und der zweiten Rückplatte (760b) angeordnet ist.

5. Anzeigevorrichtung (700) gemäß Anspruch 4, wobei das Stützelement (770) an der ersten Rückplatte (760a) und der zweiten Rückplatte (760b) angebracht ist.

6. Anzeigevorrichtung (700) gemäß irgendeinem der Ansprüche 1 bis 5, wobei die Verdrahtung aus Gold, Silber, Aluminium, Molybdän, Chrom, Titan, Nickel, Neodym, Kupfer oder einer Legierung aus Silber und Magnesium gebildet ist.

7. Anzeigevorrichtung (700) gemäß irgendeinem der Ansprüche 1 bis 5, wobei die Verdrahtung in einer dreischichtigen Struktur aus Titan/Aluminium/Titan gebildet ist.

8. Anzeigevorrichtung (700) gemäß irgendeinem der Ansprüche 1 bis 7, wobei das Ansteuer-Integrierte-Schaltung-Verbindungselement (750) mindestens eines von einem Tape Carrier Package (TCP) und einem Chip on Film (COF) ist.

9. Anzeigevorrichtung (700) gemäß irgendeinem der Ansprüche 1 bis 8, wobei die Abdeckbeschichtung (740) eine erste Dicke im ersten Bereich und eine zweite Dicke im Biegebereich hat, und wobei die erste Dicke größer als die zweite Dicke ist.

10. Anzeigevorrichtung (700) gemäß irgendeinem der Ansprüche 1 bis 9, wobei die Abdeckbeschichtung (740) ein organisches Harz aufweist.

11. Anzeigevorrichtung gemäß irgendeinem der Ansprüche 1 bis 10, wobei die Abdeckbeschichtung (740) eine Seitenfläche der Anzeigeschicht (730) vollständig bedeckt und einen Teil einer oberen Fläche der Anzeigeschicht (730) bedeckt.

## Revendications

1. Appareil d'affichage (700), comprenant :
un substrat flexible (710) comprenant une zone d'affichage (DA) et une zone de non-affichage (NA) ;
la zone de non-affichage (NA) comprenant une première zone, une zone de courbure et une deuxième zone, la deuxième zone étant courbée derrière la première zone via la zone de courbure ;
une couche d'affichage (730) sur le substrat flexible (710) ;
une couche adhésive (739) sur la couche d'affichage (730) ;
une couche de polarisation (732) sur la couche adhésive (739) ;
une couche de recouvrement (736) sur la couche de polarisation (732) ;
une deuxième couche adhésive (734) située entre la couche de polarisation (732) et la couche de recouvrement (736) ;
un élément de connexion de circuit intégré d'entraînement (750) sur la deuxième zone ;
un câblage (120) acheminé de la première zone à la deuxième zone via la zone de courbure, le câblage (120) connectant électriquement la couche d'affichage (130, 730) disposée dans la zone d'affichage (DA) à l'élément de connexion de circuit intégré d'entraînement (750) disposé dans la deuxième zone ;
un revêtement de recouvrement (740) recouvrant le câblage (120) dans la zone de courbure, le revêtement de recouvrement (740) ayant une partie de bord entre la couche d'affichage (730) et la couche adhésive (739), le revêtement de recouvrement (740) recouvrant une extrémité de l'élément de connexion de circuit intégré d'entraînement (750),
dans lequel le revêtement de recouvrement (740) est disposée à distance de la couche de recouvrement (736).

2. Appareil d'affichage (700) selon la revendication 1, comprenant en outre une première plaque arrière (760a) et une deuxième plaque arrière (760b) sous la première plaque arrière (760a) ;
dans lequel la première plaque arrière (760a) est située sous le substrat flexible (710) pour correspondre à la couche d'affichage (730) de la zone d'affichage (DA) et la deuxième plaque arrière (760b) est située au-dessus du substrat flexible (710) pour correspondre à l'élément de connexion de circuit intégré d'entraînement (750) de la deuxième zone.

3. Appareil d'affichage (700) selon la revendication 2, dans lequel une surface inférieure de la première plaque arrière (760a) fait face à une surface supérieure de la deuxième plaque arrière (760b).

4. Appareil d'affichage (700) selon la revendication 3, comprenant en outre un élément de support (770) situé entre la première plaque arrière (760a) et la deuxième plaque arrière (760b).

5. Appareil d'affichage (700) selon la revendication 4, dans lequel l'élément de support (770) est fixé à la première plaque arrière (760a) et à la deuxième plaque arrière (760b).

6. Appareil d'affichage (700) selon l'une quelconque des revendications 1 à 5, dans lequel le câblage est formé d'or, d'argent, d'aluminium, de molybdène, de chrome, de titane, de nickel, de néodyme, de cuivre ou d'un alliage d'argent et de magnésium.

7. Appareil d'affichage (700) selon l'une quelconque des revendications 1 à 5, dans lequel le câblage est formé dans une structure à trois couches de titane / aluminium / titane.

8. Appareil d'affichage (700) selon l'une quelconque des revendications 1 à 7, dans lequel l'élément de connexion de circuit intégré d'entraînement (750) est au moins l'un parmi un boîtier de support de bande (TCP) et une puce sur film (COF).

9. Appareil d'affichage (700) selon l'une quelconque des revendications 1 à 8, dans lequel le revêtement de recouvrement (740) a une première épaisseur dans la première zone et une deuxième épaisseur dans la zone de courbure, et dans lequel la première épaisseur est supérieure à la deuxième épaisseur.

10. Appareil d'affichage (700) selon l'une quelconque des revendications 1 à 9, dans lequel le revêtement de recouvrement (740) comprend une résine organique.

11. Appareil d'affichage selon l'une quelconque des revendications 1 à 10, dans lequel le revêtement de recouvrement (740) recouvre entièrement une surface latérale de la couche d'affichage (730) et recouvre une partie d'une surface supérieure de la couche d'affichage (730).
